# EUROPEAN PATENT SPECIFICATION

(11) **EP 2 804 183 B1**
(45) Date of publication and mention of the grant of the patent: **17.04.2019**
(21) Application number: 13002522.4
(22) Date of filing: 14.05.2013
(51) Int. Cl.: H01B 1/22, H01L 23/48, H05K 1/00, B32B 15/00, B32B 15/01, H05K 3/00, B32B 7/12, H01L 23/498, H05K 1/03, H05K 1/09, H05K 3/12

(54) **Brown-red cu-comprising composition and a composite comprising the brown-red cu-comprising composition**
Braunrote Cu-haltige Zusammensetzung und ein Kompositmaterial mit der braunroten Cu-haltigen Zusammensetzung
Composition comportant du cuivre brun-rouge et un matériau composite comprenant la composition comportant du cuivre brun-rouge

(43) Date of publication of application: 19.11.2014
(73) Proprietor: Fraunhofer-Gesellschaft zur Förderung der angewandten Forschung e.V., 80686 München (DE)
(72) Inventor: Bawohl, Melanie, 63454 Hanau (DE); Modes, Christina, 60439 Frankfurt a.M. (DE); Kretzschmar, Christel, 01809 Dohna (DE); Eberstein, Markus, 01069 Dresden (DE)
(74) Representative: Pfenning, Meinig & Partner mbB

(56) References cited:
- EP-A1- 0 028 819
- EP-A1- 0 046 640
- EP-A1- 0 131 778
- EP-A2- 1 761 114
- DE-A1- 3 523 061
- JP-A- S6 459 710
- JP-A- H09 157 055
- US-A- 2 993 815
- US-A- 4 072 771
- US-A- 4 172 919
- US-A- 4 376 725
- US-A- 4 497 875
- US-A- 5 490 627
- US-A- 6 033 787
- US-A1- 2002 005 507

## Description

The invention relates to a Cu-comprising composition, to a process for making such a Cu-comprising composition, to a composite comprising such a Cu-comprising composition, to a process for making such a composite and to an electronic device comprising such a composite.

Cu-comprising compositions, in particular Cu-comprising pastes, are generally known in the art. For example US 2002/0005507 A1 discloses such a paste and its application as conductive thick-film paste for wiring boards. JP 2012-054 113 A discloses a Cu comprising paste for its application on ceramic substrates. EP 0 131 778 A1 discloses thick film conductor compositions comprising finely divided particles of copper oxide-coated copper and low softening point inorganic binder dispersed in a low-resin organic medium, wherein additional copper is incorporated into the composition either by direct addition or by inclusion in the inorganic binder.

Generally an object of the present invention is to at least partly overcome a disadvantage arising form the prior art.

It is an object of the invention to provide a Cu-comprising composition suitable to form composites with thick and distinct conducting layers with good conductivity while maintaining good adhesion before and after thermal treatment.

It is a further object of the invention to provide a Cu-comprising composition suitable to form composites with thick conducting layers with a low tendency of blister formation and delamination.

It is yet another object of the invention to provide a process for preparing composites with thick conducting layers with good conductivity while maintaining good adhesion before and after thermal treatment.

It is a further object of the invention to provide a process for preparing composites with thick conducting layers with a low tendency of blister formation and delamination.

It is an object of the invention to provide a Cu-comprising composition which is free of Pb, Cd or Ni.

It is yet an other object of the invention to provide a Cu-comprising composition for cost sensitive applications.

It is an object of the invention to provide an electronic device which comprises such a composite which can conduct high currents with high overall efficiency at low cost.

A contribution to at least one of these objects is given by the independent claims. The dependent claims provide preferred embodiments of the present invention which also serve the solution of at least one of the above mentioned objects.

A contribution to the solution of at least one of these objects is made by a composition comprising as constituents:
a. at least 2 wt.-% of a vehicle;
b. at least 42 wt.-% of Cu particles;
each based on the weight of the total composition with the wt.-% of the constituents adding to 100 wt.-%;
wherein the composition has color values of L* less than 60 and a* more than14, each according to the L*a*b* color space. The color values of the composition is determined according to the test method given below. Substrate with dried composition is used for determining the color values.

The composition comprises the vehicle in an amount of at least 2 wt.-%; more preferably in an amount of at least 3 wt.-%; even more preferably in an amount of at least 4 wt.-%; and most preferably in an amount of at least 6 wt.-%, each based on the total composition.

The composition preferably comprises the Cu particles in an amount of at least about 50 wt.-%; more preferably in an amount of at least about 60 wt.-%; even more preferably in an amount of at least about 70 wt.-%; and most preferably in an amount of at least about 75 wt.-%, each based on the total composition.

A composition prepared according to the invention is also referred to as a paste. The Cu particles according to the invention are also referred to as Cu powder.

According to the invention, the composition further comprises Cu oxide in the range from 0.01 to 0.5 wt.-% based on the weight of the total composition. The composition preferably comprises the Cu oxide in the range from about 0.05 to 0.5 wt.-%; more preferably in the range from about 0.1 to 0.5 wt.-%; each based on the total composition. For the use throughout this document preferred Cu oxides are CuO and Cu₂O.

According to the invention, the composition further comprises Bi₂O₃ in the range from 2 to 10 wt.-% based on the weight of the total composition. The composition preferably comprises the Bi₂O₃ in the range from 2 to about 9 wt.-%; more preferably in the range from 2 to about 8 wt.-%; even more preferably in the range from 2 to about 7 wt.-%; and most preferably in the range from 2 to about 6 wt.-%, each based on the total composition.

According to the invention, the composition is characterized in that the Cu particles have an oxygen content in the range from 0.4 to 0.8 wt.-% based on the total weight of the Cu particles.

Preferably at least some of the Cu particles according to the embodiment comprise Cu oxide; or parts of the surfaces of at least some of the Cu particles are partly superimposed by the Cu oxide; or both. Therein the Cu oxide may be superimposed to have direct physical contact to the surface of the Cu particle or there may be additional layers, sublayers, compositions or inclusions between the Cu oxide and the surfaces of the Cu particles which are superimposed by the Cu oxide. A force which bonds the Cu oxide to a Cu particle may be any physical or chemical force. Preferred forces are cohesion, chemical bounds and intermolecular forces. Preferred intermolecular forces are Van-der-Waals-forces. It is preferred that the force is greater than the Van-der-Waals-forces.

The oxygen content of the Cu particles is based on Cu oxide. Said Cu oxide results from a heat treatment of Cu in an oxidizing atmosphere at a temperature ranging from 100 to 200°C; more preferably at a temperature ranging from about 120 to about 180°C; and most preferably at a temperature ranging from about 140 to about 160°C.

For the use throughout this document an oxidizing atmosphere is a gas or a mixture of gases comprising O as constituent. Preferably the gas has a density and an O content high enough to provide a source of O for oxidizing reactions. A source for oxidizing reactions is considered to provide as much O as can enter oxidizing reactions under the given conditions. Said conditions comprise any parameter relevant for oxidizing reactions to take place. A preferred parameter is a temperature. Preferably the oxidizing atmosphere is continuously or in discrete steps renewed during the heating. Renewing is preferably realized continuously. Renewing is more preferably implemented by a continuous supply of the oxidizing atmosphere. A preferred oxidizing atmosphere is air. Renewing is most preferably implemented by continuously purging the heating room with the oxidizing atmosphere. For the use throughout this document heating or a heat treatment preferably takes place in a heating room. A preferred heating room is a furnace. Preferred furnaces are a belt furnace, a box furnace and a chamber furnace.

In an embodiment of the invention a composition is characterized in that the composition further comprises Pd in the range from about 2.4 to about 14.4 wt.-% based on the total composition. The composition according to the embodiment preferably comprises the Pd in the range from about 3.0 to about 14.0 wt.-%; more preferably in the range from about 4.0 to about 13.0 wt.-%; even more preferably in the range from about 6.0 to about 11.0 wt.-%; and most preferably in the range from about 7.5 to about 9.5 wt.-%, each based on the total composition. The Pd may be comprised in any constituent of the composition. Preferably the Pd is comprised in the composition as an additive of the composition.

In an embodiment of the invention a composition is characterized in that the Cu particles have a particle size distribution characterized by:
a. a D₁₀ in the range from 0.5 to 3 µm;
b. a D₅₀ in the range from 1 to 10 µm; and
c. D₉₀ in the range from 2 to 20 µm.

The Cu particles according to the embodiment are preferably characterized by a D₁₀ in the range from 0.5 to 3 µm. The Cu particles according to the embodiment are preferably characterized by a D₅₀ in the range from 1 to 10 µm. The Cu particles according to the embodiment are preferably characterized by a D₉₀ in the range from 2 to 20 µm.

In an embodiment of the invention a composition is characterized in that the Cu particles have a specific surface area according to BET in the range from 0.01 to 40 m²/g. The specific surface area according to the embodiment is preferably in the range from about 0.05 to about 30 m²/g; more preferably in the range from about 0.1 to about 25 m²/g; and most preferably in the range from about 0.2 to about 20 m²/g.

In an embodiment of the invention a composition is characterized in that the Cu particles have a tap density measured in accordance with ISO 3953 in the range from about 2 to about 5 g/cm³. The tap density according to the embodiment is preferably in the range from about 2.5 to about 4.5 g/cm³; more preferably in the range from about 3.0 to about 4.0 g/cm³; and most preferably in the range from about 3.2 to about 3.8 g/cm³.

In an embodiment of the invention a composition is characterized in that the composition further comprises an inorganic reaction system, capable of forming a glass; or a glass frit; or both. The glass or glass frit may be capable of etching a layer superimposed on a conductive layer and may enable the composition to generate electrical contact with the conductive layer after firing.

In an embodiment of the invention a composition is characterized in that the composition comprises less than 0.005 wt.-% of Pb based on the total weight of the composition. The composition according to the embodiment preferably comprises less than about 0.0025 wt.-% of Pb; more preferably less than about 0.001 wt.-% of Pb, each based on the total composition; and most preferably the composition is free of Pb. Preferably the Pb content of the composition has an upper limit for environmental or health reasons or in order to meet legal provisions.

A contribution to the solution of at least one of the objects of the present invention is made by a process for making a composition according to the invention, comprising the steps:
a. providing Cu particles,
   wherein the Cu particles comprise less than 0.25 wt.-% of oxygen based on the total weight of the Cu particles;
b. heating the Cu particles in an oxidizing atmosphere to a temperature in the range from 100 to 200°C to obtain pre-oxidized Cu particles, wherein the pre-oxidized Cu particles comprise oxygen in the range from 0.4 to 0.8 wt.-% based on the total weight of the pre-oxidized Cu particles;
c. mixing as constituents:
   i) the pre-oxidized Cu particles in an amount of at least 42 wt.-%,
   ii) a vehicle in an amount of at least 2 wt.-%,
   iii) Bi₂O₃ in an amount of 2 to 10 wt.-%, and
   iv) Cu oxide in an amount of 0.01 to 0.5 wt.-%,
each based on the total weight of the mixed constituents with the wt.-% of the constituents adding to 100 wt.-%,
wherein the composition has color values of L* less than 60 and a* more than 14, each according to the L*a*b* color space.

Before pre-oxidizing the Cu particles according to the process the Cu particles have an oxygen content of less than 0.25 wt.-% based on the total weight of the Cu particles. In some instances the oxygen content is as low as 0.01 wt.-% based on the total weight of the Cu particles.

According to the process of the invention the Cu particles are heated to a temperature in the range from 100 to 200°C.

According to the process of the invention the pre-oxidized Cu particles are preferably mixed with the other constituents in an amount of at least about 50 wt.-%; more preferably in an amount of at least about 60 wt.-%; even more preferably in an amount of at least about 70 wt.-%; and most preferably in an amount of at least about 75 wt.-%, each based on the total composition. According to the invention pre-oxidized Cu particles are Cu particles which have been heated in an oxidizing atmosphere according to the invention.

According to the process of the invention the vehicle is mixed with the other constituents in an amount of at least 2 wt.-%; more preferably in an amount of at least 3 wt.-%; even more preferably in an amount of at least 4 wt.-%; and most preferably in an amount of at least 6 wt.-%, each based on the total composition.

Mixing of constituents preferably comprises manually or mechanical mixing, preferably by stirrers or dispergators, the constituents and homogenizing the constituents in a mill. Preferred mills are selected from the group consisting of 3 roll mills, ball mills and colloidal mills, or a combination of at least two thereof.

In an embodiment of the invention a process is characterized in that the constituents to be mixed further comprise Cu oxide particles in the range from about 0.06 to 0.5 wt %. According to the embodiment the Cu particles are preferably mixed with the other constituents in the range from about 0.1 to 0.5 wt.-%; more preferably in the range from about 0.15 to0.5 wt.-%; each based on the total composition.

A contribution to the solution of at least one of the objects of the present invention is made by a composition obtainable by the above process. At least one or all of the criteria mentioned below shall also apply to this composition.

In an embodiment of the invention a composition is characterized in that the composition fulfills at least one, preferably at least two or all, of the following criteria:
a. a viscosity in the range from 10 to 100 Pa s;
b. color values of the fired composition of L* less than 84 and a* more than 13, each according to the L*a*b* color space;
c. a sheet resistance of the fired composition of less than 1,2 mΩ/square; or
d. at least 90 % wire break.

Preferred compositions of the invention are characterized by each of the following combinations of the above criteria: c.d.; b.c.d.; or c.a.d..

According to the embodiment of the invention the color value L* of the dried paste is less than 60. In some cases the L* value can be as low as 20. According to the embodiment the color value a* of the dried paste is more than 14. In some cases the a* value can be as high as 40.

According to the embodiment of the invention the color value L* of the fired paste is preferably less than about 84; more preferably less than about 81; and most preferably less than about 80. In some cases the L* value can be as low as 20. According to the embodiment the color value a* of the fired paste is preferably more than about 13, more preferably more than about 13.2 and most preferably more than about 13.5. In some cases the a* value can be as high as 40.

According to a further embodiment of the disclosure, the superimposing of the compositions for forming the layers can be performed in two or more cycles in order to obtain two or more layers. It is preferred that these cycles comprise in that order a superimposing step as an applying step, optionally, preferably mandatory, a drying step, and a firing step. With regard to the preferred condition of the superimposing/applying and the firing steps reference is made to the details given below regarding the process of making a composite according to the disclosure. The drying can be performed at any temperature sufficient for reducing the amount of solvent in the composition. Preferred drying temperatures are in the range of about 50 to about 300°C, preferably in the range of about 100°C to about 250°C and more preferably in the range of about 120 to about 180°C. It is preferred to apply the drying temperature for at least about 5 minutes, preferably about 7 minutes and usually not longer than 60 minutes. The above explained cycle is called "apply-dry-fire cycle" throughout this document.

In a preferred embodiment of the disclosure the apply-dry-fire cycle can be repeated in the range from about 2 to about 20, preferably in the range from about 3 to about 15 and more preferably in the range from about 4 to about 12 cycles. It results from the present disclosure that only little preferably no formation of bubbles, cracks, blistering or dilamination or at least one thereof, in particular blistering and delamination, occurs during drying or firing or during both.

According to the embodiment of the disclosure the apply-dry-fire cycle of a composition according to the invention can be repeated several times, whereby the subsequent print covers from about 0 to about 100 % of the area of the preceding print. Preferably the subsequent print covers from about 50 to about 100 %, more preferably from about 80 to about 100 % and most preferably from about 90 to about 100 % of the area of the preceding print.

According to an embodiment of the disclosure testing of the bond adhesion after at least 3 apply-dry fire cycles and after 500 thermo-cycles is at least 90% wire break.

According to the embodiment of the disclosure the sheet resistance normalized to a filmthickness of 50 µm of the fired composition is preferably less than about 1.2 mΩ/square; more preferably less than about 1.0 mΩ/square; and most preferably less than about 0.8mQ/square.

According to an embodiment of the process of the invention for making a composition according to the invention, firing is preferably performed in a nitrogen atmosphere. Preferably the nitrogen atmosphere comprises O₂ less than about 10 ppm based on the atmosphere. Preferably the composite precursor is heated during firing to a temperature in the range from about 900 to about 950°C. Preferably the composite precursor is kept at this temperature for about 10 to about 12 minutes. Preferably a total firing cycle time is in the range form about 30 to about 60 minutes.

According to another embodiment of the invention a composite obtained according to any processes according to the invention is a subject of the invention.

A contribution to the solution of at least one of the objects of the present disclosure is made by a composite comprising:
a. a substrate layer comprising at least 70 wt.-% of a substrate compound selected from the group consisting of Si₃N₄, Al₂O₃, AlN or a combination of at least two thereof, based on the total weight of the substrate layer with the wt.-% of the constituents adding to 100 wt.-%, with a substrate surface;
b. a second layer comprising:
   i) Al or Si in the range from about 60 to about 80 wt.-%,
   ii) O in the range from about 15 to about 25 wt.-%,
   each based on the total weight of the second layer (104) with the wt.-% of the constituents adding to 100 wt.-%,
   wherein the substrate surface is superimposed by the second layer;
c. a third layer comprising:
   i) Cu in the range of at least about 70 wt.-%,
   ii) O in the range from about 0.01 to about 15 wt.-%,
   each based on the total weight of the third layer with the wt.-% of the constituents adding to 100 wt.-%,
   wherein the second layer is superimposed by the third layer.

The substrate layer according to the above composite comprises preferably at least 80 wt.-% of the substrate compound; more preferably at least 90 wt.-% of the substrate compound; and most preferably at least 95 wt.-% of the substrate compound, each based on the total weight of the substrate layer.

The second layer according to the above composite comprises Al or Si preferably in the range from about 62 to about 78 wt.-%; more preferably range from about 65 to about 75 wt.-%; and most preferably range from about 68 to about 72 wt.-%, each based on the total weight of the second layer. The second layer according to the above composite comprises O preferably in the range from about 16 to about 24 wt.-%; more preferably range from about 18 to about 22 wt.-%; and most preferably range from about 19 to about 21 wt.-%, each based on the total weight of the second layer.

The third layer according to the above composite comprises Cu preferably in an amount of at least 72 wt.-%; more preferably in an amount of at least 75 wt.-%; and most preferably in an amount of at least 80 wt.-%, each based on the total weight of the third layer. The third layer according to the above composite comprises O preferably in the range from about 0.01 to about 10 wt.-%; more preferably in the range from about 0.1 to about 10 wt.-%; and most preferably in the range from about 0.5 to about 8 wt.-%, each based on the total weight of the third layer.

For the use throughout this document wherever Al, Si, Bi, Cu or O are given as constituents of the layers or sublayers of a composite Al, Si, Bi, Cu and O may be comprised in the layers or sublayers of the composite as elements or in form of a compound or both. Preferred compounds comprising O are oxides. Preferred oxides are Cu oxides, Al oxides and Bi oxides. A preferred Al oxide is Al₂O₃. Preferred Cu oxides are CuO and Cu₂O. A preferred Bi oxide is Bi₂O₃.

For the use throughout this document wherever a layer, a sublayer or a composition is superimposed on another layer, a sublayer or a substrate surface the layer, sublayer or composition may be superimposed to have direct physical contact to the other layer, sublayer or substrate surface or there may be additional layers, sublayers, compositions or inclusions between the two bodies which are superimposed on each other.

In an embodiment of the disclosure a composite is characterized in that the substrate compound is AlN. The substrate layer according to the composite comprises preferably at least 80 wt.-% of the AlN; more preferably at least 90 wt.-% of the AlN; and most preferably at least 95 wt.-% of the AlN, each based on the total weight of the substrate layer.

In an embodiment of the disclosure a composite is characterized in that the second layer further comprises Cu in an amount of about 0.01 to about 10 wt.-% based on the total weight of the second layer. The second layer according to the embodiment comprises Cu preferably in an amount of about 0.1 to about 10 wt.-%; more preferably in an amount of about 1 to about 10 wt.-%; more preferably in an amount of about 2 to about 9 wt.-%; more preferably in an amount of about 3 to about 8 wt.-%; and most preferably in an amount of about 4 to about 7 wt.-%, each based on the total weight of the second layer.

In an embodiment of the disclosure a composite is characterized in that the second layer comprises a first sublayer comprising
a. Al in the range from about 70 to about 80 wt.-%,
b. Cu in an amount of less than about 2 wt.-%,
each based on the total weight of the first sublayer,
wherein the first sublayer superimposes the substrate surface.

The first sublayer according to the above embodiment comprises Al preferably in the range from about 72 to about 78 wt.-%; more preferably in the range from about 73 to about 77 wt.-%; and most preferably in the range from about 74 to about 76 wt.-%, each based on the total weight of the first sublayer. The first sublayer according to the embodiment comprises Cu preferably in an amount less than about 1.5 wt.-%; more preferably in an amount less than about 1 wt.-%; and most preferably in an amount less than about 0.5 wt.-%, each based on the total weight of the first sublayer.

For the use throughout this document a sublayer is a layer which is spatially located within the layer which comprises the sublayer. Preferably the sublayer is spatially completely located within the layer which comprises the sublayer. Preferably surfaces of the sublayer are oriented in the same direction as a surface of the layer which comprises said sublayer.

In an embodiment of the disclosure a composite is characterized in that the second layer comprises a second sublayer comprising
a. Al in the range from about 50 to about 70 wt.-%,
b. Cu in the range from about 2 to about 20 wt.-%,
each based on the total weight of the second sublayer,
wherein the second sublayer superimposes one of the group consisting of the substrate surface and the first sublayer or a combination of the two.

The second sublayer according to the above embodiment comprises Al preferably in the range from about 52 to about 68 wt.-%; more preferably in the range from about 50 to about 65 wt.-%; and most preferably in the range from about 55 to about 60 wt.-%, each based on the total weight of the second sublayer. The second sublayer according to the above embodiment comprises Cu preferably in the range from about 5 to about 15 wt.-%; more preferably in the range from about 7 to about 13 wt.-%; and most preferably in the range from about 9 to about 11 wt.-%, each based on the total weight of the second sublayer.

In an embodiment of the disclosure a composite is characterized in that the second layer comprises a third sublayer comprising
a. Al in the range from about 30 to about 50 wt.-%,
b. Cu in the range from about 20 to about 45 wt.-%,
each based on the total weight of the third sublayer,
wherein the third sublayer superimposes one of the group consisting of the substrate surface, the first sublayer and the second sublayer or a combination of at least two thereof.

The third sublayer according to the above embodiment comprises Al preferably in the range from about 32 to about 48 wt.-%; more preferably in the range from about 35 to about 45 wt.-%; and most preferably in the range from about 37 to about 43 wt.-%, each based on the total weight of the third sublayer. The third sublayer according to the above embodiment comprises Cu preferably in the range from about 25 to about 40 wt.-%; more preferably in the range from about 20 to about 35 wt.-%; and most preferably in the range from about 28 to about 32 wt.-%, each based on the total weight of the third sublayer.

A contribution to the solution of at least one of the objects of the present invention is made by a process for making a composite, comprising the steps
a. providing a substrate with a substrate surface;
b. superimposing a composition comprising
   i) at least 2 wt.-% of a vehicle,
   ii) Cu particles in an amount of at least 42 wt.-%,
   each based on the total weight of the composition with the wt.-% of the constituents adding to 100 wt.-%,
   wherein the composition has color values of L* less than 60 and a* more than 14, each according to the L*a*b* color space,
   wherein the Cu particles comprise oxygen in the range from 0.4 to 0.8 wt.-% based on the total weight of the Cu particles,
   wherein the composition further comprises
   a. Bi₂O₃ in the range from 2 to 10 wt.-%;
   b. Cu oxide in the range from 0.01 to 0.5 wt.-%;
   each based on the total weight of the composition with the wt.-% of the constituents adding to 100 wt.-%,
   on the substrate surface in order to obtain a composite precursor;
c. firing the composite precursor.

The substrate according to the process comprises preferably as a substrate compound at least about 70 wt.-% Al₂O₃, more preferably at least 80 wt.-% of Al₂O₃; more preferably at least 90 wt.-% of Al₂O₃; and most preferably at least 95 wt.-% of Al₂O₃, each based on the total weight of the substrate.

According to the process of the invention the composition comprises the vehicle in an amount of at least 2 wt.-%; more preferably in an amount of at least 3 wt.-%; even more preferably in an amount of at least 4 wt.-%; and most preferably in an amount of at least 6 wt.-%, each based on the total composition.

According to the process of the invention the Cu particles comprise the oxygen in the range from 0.4 to 0.8 wt.-%, each based on the total weight of the Cu particles.

Firing is carried out as described above or below under test methods.

The process according to the invention is characterized in that the composition further comprises
a. Bi₂O₃ in the range from 2 to 10 wt.-%;
b. Cu oxide in the range from 0.01 to 0.5 wt.-%;
each based on the total weight of the composition with the wt.-% of the constituents adding to 100 wt.-%.

According to the above the composition comprises Bi₂O₃ in the range from 2 to 10.0 wt.-%; more preferably in the range from 2 to about 8.0 wt.-%; even more preferably in the range from 2 to about 7.0 wt.-%; and most preferably in the range from 2 to about 6.0 wt.-%, each based on the total composition. According to the process of the invention the composition comprises preferably the Cu oxide in the range from 0.01 to 0.5 wt.-%; more preferably in the range from about 0.1 to 0.5 wt.-%; each based on the total composition. Preferred Cu oxides are CuO and Cu₂O. Preferably the composition according to the process of the invention is a composition as described above.

In an embodiment of the invention a process is characterized in that
a. the substrate comprises at least 70 wt.-% of AlN, based on the total weight of the substrate;
b. the process comprises as further steps before superimposing:
   i) heating the substrate to a temperature in the range of 1000 to 1300°C,
   ii) exposing the hot substrate to an oxidizing atmosphere. It is preferred that steps i) and ii) at least partially overlap.

According to the process of the invention the substrate is heated preferably to a temperature in the range of 1000 to about 1250°C; more preferably to a temperature in the range of about 1050 to about 1200°C; and most preferably to a temperature in the range of about 1100 to about 1200°C. The steps heating the substrate and exposing the hot substrate to an oxidizing atmosphere may overlap. Preferably the substrate is exposed to an oxidizing atmosphere during the whole heating step. A hot substrate is the substrate at a temperature which is high enough to allow oxidizing reactions of the substrate with the oxidizing atmosphere. The substrate is preferably heated in order to form an Al oxide. Preferred Al oxides are AlON and Al₂O₃, wherein Al₂O₃ is most preferred. Preferably the Al oxide is formed as a layer which superimposes the substrate surface.

According to the process of the invention the substrate is preferably cooled to ambient temperature before superimposing the composition. Preferably the substrate is cooled actively to ambient temperature before superimposing.

In an embodiment of the invention a process is characterized in that the thickness of the composition superimposed on the substrate surface is a non-constant function of the location on the substrate surface. According to the embodiment the composition is preferably superimposed on the substrate surface to form a pattern. The pattern may be spatially periodical or not periodical. Preferably the pattern comprises a plurality of paths. More preferably the composition is superimposed on the substrate surface to form conducting paths on a circuit board. In an embodiment of the invention a process is characterized in that the superimposing is realized as one selected from the group consisting of screen printing, stencil printing, tampon printing, dispensing through a nozzle, or a combination of at least two thereof.

A contribution to the solution of at least one of the objects of the present invention is made by a composite obtainable by a process as described above. The below given features and criteria also apply to this composite.

In an embodiment of the disclosure a composite is characterized in that the second layer comprises Bi in the range from about 1 to about 15 wt.-% based on the total weight of the second layer. The second layer according to the embodiment comprises preferably Bi in the range from about 2 to about 13 wt.-%; more preferably in the range from about 3 to about 11 wt.-%; even more preferably in the range from about 5 to about 9 wt.-%; and most preferably in the range from about 6 to about 8 wt.-%, each based on the total weight of the second layer.

A contribution to the solution of at least one of the objects of the present disclosure is made by a composite comprising:
a. a substrate layer comprising at least 90 % Al₂O₃, based on the total weight of the substrate with a substrate surface;
b. a second layer comprising:
   i) Al₂O₃ in the range from about 80 to about 95 wt.-%,
   ii) Cu in the range from about 0,1 to about 5 wt.-%,
   each based on the total weight of the second layer with the wt.-% of the constituents adding to 100 wt.-%,
   wherein the substrate surface is superimposed by the second layer;
c. a third layer comprising:
   i) Cu in the range of at least about 70 wt.-%,
   ii) O in the range from about 0,01 to about 15 wt.-%,
   each based on the total weight of the third layer with the wt.-% of the constituents adding to 100 wt.-%,
   wherein the second layer is superimposed by the third layer.

In an embodiment of the invention, the substrate layer of the composite has a thickness in the range of 0.01 to a 10 mm. In an embodiment of the disclosure, a composite fulfills at least one, preferably at least two or all, of the following criteria:
a. the substrate layer has a thickness in the range of about 0.01 to about 10 mm;
b. the second layer has a thickness in the range of about 0.5 to 5 µm;
c. the third layer has a thickness in the range of about 10 to 600 µm; or
d. the thickness of the third layer is a non-constant function of the location within the layer plane.

Preferred composites of the disclosure are characterized by each of the following combinations of the above criteria: a.c.; b.c.; c.d.; a.b.c; b.c.d.; c.a.d.; or a.b.c.d..

According to the above embodiment the substrate layer preferably has a thickness in the range of about 0.01 to about 10 mm; more preferably in the range of about 0.05 to about 8.0 mm; and most preferably in the range of about 0.1 to about 5 mm.

According to the above embodiment the second layer preferably has a thickness in the range of about 0.6 to about 4.5 µm; more preferably in the range of about 1 to about 4 µm; and most preferably in the range of about 1.5 to about 3 µm.

According to the above embodiment the third layer preferably has a thickness in the range of about 10 to about 600 µm; more preferably in the range of about 20 to about 400 µm; and most preferably in the range of about 50 to about 300 µm.

According to the above embodiment the thickness of the third layer preferably forms a pattern. The pattern may be spatially periodical or not periodical. Preferably the pattern comprises a plurality of paths. More preferably the third layer forms conducting paths on a circuit board.

For the use throughout this document a thickness of a layer or a sublayer is a shortest distance between one point on a first surface of the layer or the sublayer and a second surface of the layer or the sublayer wherein the second surface is in contact with a surface of another layer, or in contact with another sublayer or in contact with a substrate surface.

According to another embodiment of the invention the thickness of the third layer obtained by at least 1cycle of the apply-dry-fire cycle(s), also denoted final fired film thickness, is at least about 10 µm, preferably about 20 µm, more preferably about 30 µm, most preferably about 40 µm and can in some cases reach up to about 100 µm. According to an embodiment of the invention the final fired thickness after at least 5 apply-dry-fire cycles is at least about 100 µm, preferably about 200 µm, more preferably about 250 µm and most preferably about 300 µm and in some cases it may reach up to about 500 µm.

A contribution to the solution of at least one of the objects of the present invention is made by an electronic device comprising a composite according to the invention. The electronic device according to the invention preferably involves one selected from the group consisting of high electrical currents, high heat loads (temperatures of up to 900°C), parts of the electronic device which get heated during operation of the electronic device. Parts of the electronic device which have to be cooled or a combination of at least two thereof. Preferably the composite is used in the electronic device for its electrical or thermal properties. More preferably the composite is used in the electronic device in order to conduct high currents or in order to conduct heat or both.

For the use throughout this document high currents refer to currents in the range from about 50 to about 400 A. Preferred high currents are in the range from about 50 to about 300 A. More preferred high currents are in the range from about 80 to about 300 A.

In an embodiment if the invention the electronic device is selected from the group consisting of a high-power device, a high-power diode, a micro-electronic device, a sensor, a transmitter, a thick-film component, a thin-film component, a component of a satellite, an electronic circuit, an integrated electronic circuit, a heating device, a cooling device, a laser diode, a power converter, an electric motor, or a combination of at least two thereof. Therein high-power devices and high-power diodes are referred to as devices and diodes which in operation involve high currents according to the definition above.

### Cu particles

It is well known to the person skilled in the art that Cu particles can exhibit a variety of shapes, surfaces, sizes, specific surface area or surface area to volume ratios. A large number of shapes are known to the person skilled in the art. Some examples are spherical, angular, elongated (rod or needle like) and flat (sheet like). Cu particles may also be present as a combination of particles of different shapes. Cu particles with a shape, or combination of shapes, which favours advantageous sintering, electrical contact, adhesion and electrical conductivity of the produced composition are preferred according to the invention. One way to characterise such shapes without considering surface nature is through the parameters length, width and thickness. In the context of the invention the length of a particle is given by the length of the longest spatial displacement vector, both endpoints of which are contained within the particle. The width of a particle is given by the length of the longest spatial displacement vector perpendicular to the length vector defined above both endpoints of which are contained within the particle. The thickness of a particle is given by the length of the longest spatial displacement vector perpendicular to both the length vector and the width vector, both defined above, both endpoints of which are contained within the particle. In one embodiment according to the invention, Cu particles with as uniform a shape as possible are preferred i.e. shapes in which the ratios relating the length, the width and the thickness are as close as possible to 1, preferably all ratios lying in a range from about 0.7 to about 1.5, more preferably in a range from about 0.8 to about 1.3 and most preferably in a range from about 0.9 to about 1.2. Examples of preferred shapes for the Cu particles in this embodiment are therefore spheres and cubes, or combinations thereof, or combinations of one or more thereof with other shapes. In one embodiment of the invention, the Cu particles in the composition are spherical. In another embodiment according to the invention, Cu particles are preferred which have a shape of low uniformity, preferably with at least one of the ratios relating the dimensions of length, width and thickness being above about 1.5, more preferably above about 3 and most preferably above about 5. Preferred shapes according to this embodiment are flake shaped, rod or needle shaped, or a combination of flake shaped, rod or needle shaped with other shapes.

A variety of surface types are known to the person skilled in the art. Surface types which favour effective sintering and yield advantageous electrical contact and conductivity of produced compositions are favoured for the surface type of the Cu particles according to the invention

### Inorganic Reaction System

Inorganic reaction system, preferably glass frit, is present in the composition according to the invention in order to bring about etching and sintering. Preferred inorganic reaction systems are preferably either glasses, preferably glass frit, or materials which are capable of forming glasses on firing. Effective etching is required to etch through any additional layers which may have been applied to the substrate as well as to etch into the substrate to an appropriate extent. Preferred, inorganic reaction systems, preferably glass frits, in the context of the invention are powders of amorphous or partially crystalline solids which exhibit a glass transition. The glass transition temperature T_{g} is the temperature at which an amorphous substance transforms from a rigid solid to a partially mobile undercooled melt upon heating. Methods for the determination of the glass transition temperature are well known to the person skilled in the art. The etching and sintering brought about by the inorganic reaction system, preferably the glass frit, occurs above the glass transition temperature of the inorganic reaction system, preferably the glass frit, and it is preferred that the glass transition temperature lie below the desired peak firing temperature. Inorganic reaction systems, preferably glass frits, are well known to the person skilled in the art. All inorganic reaction systems, preferably glass frits, known to the person skilled in the art and which he considers suitable in the context of the invention can be employed as the inorganic reaction system in the composition.

In the context of the invention, the inorganic reaction system, preferably the glass frit, present in the composition preferably comprises elements, oxides, compounds which generate oxides on heating, other compounds, or mixtures thereof. Preferred elements in this context are Si, B, P, Se, Al, Bi, Li, Na, Mg, Pb, Zn, Gd, Ce, Zr, Ti, Mn, Sn, Ru, Co, Fe, Cu, Ba, Te, V, Nb and Cr or mixtures of two or more from this list. Preferred oxides which can be comprised by the inorganic reaction system, preferably the glass frit, in the context of the invention are alkali metal oxides, alkali earth metal oxides, rare earth oxides, group V and group VI oxides, other oxides, or combinations thereof. Preferred alkali metal oxides in this context are sodium oxide, lithium oxide, potassium oxide, rubidium oxides, caesium oxides or combinations thereof. Preferred alkali earth metal oxides in this context are beryllium oxide, magnesium oxide, calcium oxide, strontium oxide, barium oxide, or combinations thereof. Preferred group V oxides in this context are phosphorous oxides, such as P₂O₅, bismuth oxides, such as Bi₂O₃, or combinations thereof. Preferred group VI oxides in this context are tellurium oxides, such as TeO₂, or TeO₃ selenium oxides, such as SeO₂, or combinations thereof. Preferred rare earth oxides are cerium oxide, such as CeO₂ and lanthanum oxides, such as La₂O₃. Other preferred oxides in this context are silicon oxides, such as SiO₂, zinc oxides, such as ZnO, aluminium oxides, such as Al₂O₃, germanium oxides, such as GeO₂, vanadium oxides, such as VO, V₂O₃, VO₂, V₂O₅, niobium oxides, such as Nb₂O₅, boron oxide, tungsten oxides, such as WO₃, molybdenum oxides, such as MoO₃, and indium oxides, such as In₂O₃, further oxides of those elements listed above as preferred elements, or combinations thereof. Preferred oxides are also mixed oxides containing at least two of the elements listed as preferred elemental constituents of the inorganic reaction system, preferably the frit glass, or mixed oxides which are formed by heating at least one of the above named oxides with at least one of the above named metals. Mixtures of at least two of the above-listed oxides and mixed oxides are also preferred in the context of the invention.

As mentioned above, it is preferred for the inorganic reaction system, preferably the glass frit, to have a glass transition temperature below the desired firing temperature of the composition. In one embodiment of the invention the inorganic reaction system, preferably the glass frit, has a glass transition temperature in the range from about 250 to about 530 °C, more preferably in a range from about 300 to about 500 °C, and most preferably in a range from about 320 to about 450 °C.

It is well known to the person skilled in the art that glass frit particles can exhibit a variety of shapes, surface natures, sizes, surface area to volume ratios, and coating layers.
A large number of shapes of glass frit particles are known to the person skilled in the art. Some examples are spherical, angular, elongated (rod or needle like) and flat (sheet like). Glass frit particles may also be present as a combination of particles of different shapes. Glass frit particles with a shape, or combination of shapes, which favours advantageous sintering, adhesion, electrical contact and electrical conductivity of the produced composite layer are preferred according to the invention.

### Vehicle

Preferred vehicles are inorganic and organic vehicles. A preferred inorganic vehicle is water. Preferred organic vehicles in the context of the invention are solutions, emulsions or dispersions based on one or more solvents, preferably an organic solvent, which ensure that the constituents of the electro-conductive paste are present in a dissolved, emulsified, or dispersed form. Preferred organic vehicles are those which provide optimal stability of constituents within the composition and endow the composition with a viscosity allowing effective printability. Preferred organic vehicles according to the invention comprise as vehicle components:
(i) a binder, preferably in a range from about 1 to about 50 wt. %, more preferably in a range from about 2 to about 45 wt. % and most preferably in a range from about 3 to about 40 wt. %;
(ii) a surfactant, preferably in a range from about 0 to about 10 wt. %, more preferably in a range from about 0 to about 8 wt. % and most preferably in a range from about 0 to about 6 wt. %;
(ii) one or more solvents, the proportion of which is determined by the proportions of the other constituents in the organic vehicle;
(iv) optional additives, preferably in range from about 0 to about 10 wt. %, more preferably in a range from about 0 to about 8 wt.% and most preferably in a range from about 0 to about 5 wt. %,
wherein the wt. % are each based on the total weight of the organic vehicle and add up to 100 wt. %. According to the invention preferred organic vehicles are those which allow for the preferred high level of printability of the composition described above to be achieved.

### Binder

Preferred binders in the context of the invention are those which contribute to the formation of a composition with favourable stability, printability, viscosity, sintering and etching properties. Binders are well known to the person skilled in the art. All binders which are known to the person skilled in the art and which he considers to be suitable in the context of this invention can be employed as the binder in the organic vehicle. Preferred binders according to the invention (which often fall within the category termed "resins") are polymeric binders, monomeric binders, and binders which are a combination of polymers and monomers. Polymeric binders can also be copolymers wherein at least two different monomeric units are contained in a single molecule. Preferred polymeric binders are those which carry functional groups in the polymer main chain, those which carry functional groups off of the main chain and those which carry functional groups both within the main chain and off of the main chain. Preferred polymers carrying functional groups in the main chain are for example polyesters, substituted polyesters, polycarbonates, substituted polycarbonates, polymers which carry cyclic groups in the main chain, poly-sugars, substituted poly-sugars, polyurethanes, substituted polyurethanes, polyamides, substituted polyamides, phenolic resins, substituted phenolic resins, copolymers of the monomers of one or more of the preceding polymers, optionally with other co-monomers, or a combination of at least two thereof. Preferred polymers which carry cyclic groups in the main chain are polyvinylbutylate (PVB) and its derivatives and poly-terpineol and its derivatives or mixtures thereof. Preferred poly-sugars are for example cellulose and alkyl derivatives thereof, preferably methyl cellulose, ethyl cellulose, propyl cellulose, butyl cellulose and their derivatives and mixtures of at least two thereof. Preferred polymers which carry functional groups off of the main polymer chain are those which carry amide groups, those which carry acid and/or ester groups, often called acrylic resins, or polymers which carry a combination of aforementioned functional groups, or a combination thereof. Preferred polymers which carry amide off of the main chain are for example polyvinyl pyrrolidone (PVP) and its derivatives. Preferred polymers which carry acid and/or ester groups off of the main chain are for example polyacrylic acid and its derivatives, polymethacrylate (PMA) and its derivatives or polymethylmethacrylate (PMMA) and its derivatives, or a mixture thereof. Preferred monomeric binders according to the invention are ethylene glycol based monomers, terpineol resins or rosin derivatives, or a mixture thereof. Preferred monomeric binders based on ethylene glycol are those with ether groups, ester groups or those with an ether group and an ester group, preferred ether groups being methyl, ethyl, propyl, butyl, pentyl hexyl and higher alkyl ethers, the preferred ester group being acetate and its alkyl derivatives, preferably ethylene glycol monobutylether monoacetate or a mixture thereof. Alkyl cellulose, preferably ethyl cellulose, its derivatives and mixtures thereof with other binders from the preceding lists of binders or otherwise are the most preferred binders in the context of the invention.

### Surfactant

Preferred surfactants in the context of the invention are those which contribute to the formation of a composition with favourable stability, printability, viscosity, sintering and etching properties. Surfactants are well known to the person skilled in the art. All surfactants which are known to the person skilled in the art and which he considers to be suitable in the context of this invention can be employed as the surfactant in the organic vehicle. Preferred surfactants in the context of the invention are those based on linear chains, branched chains, aromatic chains, fluorinated chains, siloxane chains, polyether chains and combinations thereof. Preferred surfactants are single chained double chained or poly chained. Preferred surfactants according to the invention have non-ionic, anionic, cationic, or zwitterionic heads. Preferred surfactants are polymeric and monomeric or a mixture thereof. Preferred surfactants according to the invention can have pigment affinic groups, preferably hydroxyfunctional carboxylic acid esters with pigment affinic groups (e.g., DISPERBYK®-108, manufactured by BYK USA, Inc.), acrylate copolymers with pigment affinic groups (e.g., DISPERBYK®-116, manufactured by BYK USA, Inc.), modified polyethers with pigment affinic groups (e.g., TEGO® DISPERS 655, manufactured by Evonik Tego Chemie GmbH), other surfactants with groups of high pigment affinity (e.g., TEGO® DISPERS 662 C, manufactured by Evonik Tego Chemie GmbH). Other preferred polymers according to the invention not in the above list are polyethyleneglycol and its derivatives, and alkyl carboxylic acids and their derivatives or salts, or mixtures thereof. The preferred polyethyleneglycol derivative according to the invention is poly(ethyleneglycol)acetic acid. Preferred alkyl carboxylic acids are those with fully saturated and those with singly or poly unsaturated alkyl chains or mixtures thereof. Preferred carboxylic acids with saturated alkyl chains are those with alkyl chains lengths in a range from about 8 to about 20 carbon atoms, preferably C₉H₁₉COOH (capric acid), C₁₁H₂₃COOH (Lauric acid), C₁₃H₂₇COOH (myristic acid) C₁₅H₃₁COOH (palmitic acid), C₁₇H₃₅COOH (stearic acid) or mixtures thereof. Preferred carboxylic acids with unsaturated alkyl chains are C₁₈H₃₄O₂ (oleic acid) and C₁₈H₃₂O₂ (linoleic acid).

### Solvent

Preferred solvents according to the invention are constituents of the composition which are removed from the composition to a significant extent during firing, preferably those which are present after firing with an absolute weight reduced by at least about 80% compared to before firing, preferably reduced by at least about 95% compared to before firing. Preferred solvents according to the invention are those which allow a composition to be formed which has favourable viscosity, printability, stability and sintering characteristics and which yields composite layers with favourable electrical conductivity and electrical contact to the substrate. Solvents are well known to the person skilled in the art. All solvents which are known to the person skilled in the art and which he considers to be suitable in the context of this invention can be employed as the solvent in the organic vehicle. According to the invention preferred solvents are those which allow the preferred high level of printability of the composition as described above to be achieved. Preferred solvents according to the invention are those which exist as a liquid under standard ambient temperature and pressure (SATP) (298.15 K, 100 kPa), preferably those with a boiling point above about 90 °C and a melting point above about -20 °C. Preferred solvents according to the invention are polar or non-polar, protic or aprotic, aromatic or non-aromatic or ionic liquids. Preferred solvents according to the invention are mono-alcohols, di-alcohols, poly-alcohols, mono-esters, di-esters, poly-esters, monoethers, di-ethers, poly-ethers, solvents which comprise at least one or more of these categories of functional group, optionally comprising other categories of functional group, preferably cyclic groups, aromatic groups, unsaturated-bonds, alcohol groups with one or more O atoms replaced by heteroatoms, ether groups with one or more O atoms replaced by heteroatoms, esters groups with one or more O atoms replaced by heteroatoms, and mixtures of two or more of the aforementioned solvents. Preferred esters in this context are di-alkyl esters of adipic acid, preferred alkyl constituents being methyl, ethyl, propyl, butyl, pentyl, hexyl and higher alkyl groups or combinations of two different such alkyl groups, preferably dimethyladipate, and mixtures of two or more adipate esters. Preferred ethers in this context are diethers, preferably dialkyl ethers of ethylene glycol, preferred alkyl constituents being methyl, ethyl, propyl, butyl, pentyl, hexyl and higher alkyl groups or combinations of two different such alkyl groups, and mixtures of two diethers. Preferred alcohols in this context are primary, secondary and tertiary alcohols, preferably tertiary alcohols, terpineol and its derivatives being preferred, or a mixture of two or more alcohols. Preferred solvents which combine more than one different functional groups are 2,2,4-trimethyl-1,3-pentanediol monoisobutyrate, often called texanol, and its derivatives, 2-(2-ethoxyethoxy)ethanol, often known as carbitol, its alkyl derivatives, preferably methyl, ethyl, propyl, butyl, pentyl, and hexyl carbitol, preferably hexyl carbitol or butyl carbitol, and acetate derivatives thereof, preferably butyl carbitol acetate, or mixtures of at least 2 of the aforementioned.

### Additives in the organic vehicle

Preferred additives in the organic vehicle are those additives which are distinct from the aforementioned vehicle components and which contribute to favourable properties of the composition, such as advantageous viscosity, sintering, electrical conductivity of the produced composite layer and good electrical contact with substrates. All additives known to the person skilled in the art and which he considers to be suitable in the context of the invention can be employed as additive in the organic vehicle. Preferred additives according to the invention are thixotropic agents, viscosity regulators, stabilising agents, inorganic additives, thickeners, emulsifiers, dispersants or pH regulators. Preferred thixotropic agents in this context are carboxylic acid derivatives, preferably fatty acid derivatives or combinations thereof. Preferred fatty acid derivatives are C₉H₁₉COOH (capric acid), C₁₁H₂₃COOH (Lauric acid), C₁₃H₂₇COOH (myristic acid) C₁₅H₃₁COOH (palmitic acid), C₁₇H₃₅COOH (stearic acid) C₁₈H₃₄O₂ (oleic acid), C₁₈H₃₂O₂ (linoleic acid) or combinations thereof. A preferred combination comprising fatty acids in this context is castor oil.

### Additives in the composition

Preferred additives in the context of the invention are constituents added to the composition, in addition to the other constituents explicitly mentioned, which contribute to increased performance of the composition, of the composite layers produced thereof or of the resulting electronic device. All additives known to the person skilled in the art and which he considers suitable in the context of the invention can be employed as additive in the composition. In addition to additives present in the vehicle, additives can also be present in the composition. Preferred additives according to the invention are thixotropic agents, viscosity regulators, emulsifiers, stabilising agents or pH regulators, inorganic additives, thickeners and dispersants or a combination of at least two thereof, whereas inorganic additives are most preferred. Preferred inorganic additives in this context according to the invention are B, V, Nb, Mg, Ni, Te, W, Zn, Mg, Gd, Ce, Zr, Ti, Mn, Sn, Ru, Rh, Co, Fe, Cu and Cr or a combination of at least two thereof, preferably Zn, Sb, Mn, Ni, W, Te and Ru or a combination of at least two thereof, oxides thereof, compounds which can generate those metal oxides on firing, or a mixture of at least two of the aforementioned metals, a mixture of at least two of the aforementioned oxides, a mixture of at least two of the aforementioned compounds which can generate those metal oxides on firing, or mixtures of two or more of any of the above mentioned.

### Printing

The composition can be superimposed on a substrate surface in any manner known to the person skilled in that art and which he considers suitable in the context of the invention including but not limited to impregnation, dipping, pouring, dripping on, injection, spraying, knife coating, curtain coating, brushing or printing or a combination of at least two thereof, wherein preferred printing techniques are ink-jet printing, screen printing, tampon printing, offset printing, relief printing or stencil printing or a combination of at least two thereof. It is preferred according to the invention that the composition is applied by printing, preferably by screen printing. In one embodiment of the invention, the composition is applied to the substrate surface through a screen. In one aspect of this embodiment the application through a screen satisfies at least one, preferably at least two or all, of the following parameters:
- mesh count in a range from about 10 to about 400, preferably in a range from about 20 to about 350, more preferably in a range from about 30 to about 300, more preferably in a range from about 40 to about 250, even more preferably in a range from about 40 to about 200, most preferably in a range from about 50 to about 120;
- wire thickness in a range from about 10 to about 100 µm, preferably in a range from about 20 to about 80 µm, more preferably in a range from about 30 to about 70 µm, most preferably in a range from about 40 to about 65 µm;
- Emulsion over mesh (EoM) thickness in a range from about 5 to about 100 µm, preferably in a range from about 10 to about 80 µm, more preferably in a range from about 20 to about 70 µm, most preferably in a range from about 30 to about 60 µm;
- Conductor track spacing in a range from about 0.1 to about 3 mm, preferably in a range from about 0.15 to about 2.5 mm, more preferably in a range from about 0.2 to about 1 mm.

### Firing

It is preferred according to the invention for a composite to be made by superimposing a composition and then firing said composition to solidify composite layers. Firing is well known to the person skilled in the art and can be carried out in any manner known to him and which he considers suitable in the context of the invention. Firing must be carried out above the glass transition temperature of at least one glass frit if a glass frit is present in the composition, preferably of two or more glass frits and more preferably all glass frits present in the composition.

In one embodiment of the invention, the firing stage satisfies at least one, preferably at least two or all, of the following criteria:
- holding temperature measured according to the method titled "temperature profile in the firing furnace" given below, in a range from about 700 to about 1000 °C, preferably in a range from about 800 to about 950 °C;
- time at the holding temperature in a range from about 1 second to about 20 minutes.

It is preferred according to the invention for firing to be carried out with a holding time in a range from about 1 second to about 15 minutes, more preferably in a range from about 5 seconds to about 12 minutes and most preferably in a range from about 7 seconds to about 10 minutes.

Firing of compositions on the front and back faces of a substrate can be carried out simultaneously or sequentially. Simultaneous firing is appropriate if the compositions superimposed on both faces have similar, preferably identical, optimum firing conditions. Where appropriate, it is preferred according to the invention for firing to be carried out simultaneously.

The invention is now more closely illustrated by figures, test methods and non-limiting examples.

### TEST METHODS

The following test methods are used in the invention. In absence of a test method, the ISO test method for the feature to be measured being closest to the earliest filing date of the present application applies. In absence of distinct measuring conditions, standard ambient temperature and pressure (SATP) as a temperature of 298.15 K (25 °C, 77 °F) and an absolute pressure of 100 kPa (14.504 psi, 0.986 atm) apply.

### Organic vehicle V

The organic vehicle V was prepared using 35 parts by weight of Paraloid B67 100% (from Rohm and Haas) and 65 parts by weight Texanol (from Aldrich). Texanol was heated to 80°C and Paraloid added in small portions while stirring with a HTrieb type 4IIWM (from Heynau Gears Production Service GmbH) equipped with a disk stirrer (10 cm diameter, 12 teeth) until a clear solution was obtained.

### Cu powders

Copper powder MT150 (commercially available from Ecka Granules GmbH) named PI in the following. The copper powders P2 to P4 were obtained by heating copper powder in an oven in air at 150°C for several hours and removed from the oven when the desired oxygen content was achieved.

**Table 1:**

| Powder | D₁₀ in µm | D₅₀ in µm | D₉₀ in µm | Specific surface area in m²/g | Oxygen content in ppm |
|---|---|---|---|---|---|
| P1 | 2.19 | 3.21 | 4.48 | 0.46 | 1507 |
| P2 | 1.77 | 2.56 | 3.57 | 0.56 | 4895 |
| P3 | 1.41 | 2.22 | 3.31 | 0.75 | 5895 |
| P4 | 1.80 | 2.67 | 3.91 | 0.73 | 7565 |

### Preparation of pastes

The pastes were prepared by manually mixing the components in a glass beaker. These premixed pastes were then homogenized with a three roll mill Exakt E80 (from EXAKT Advanced Technologies GmbH) equipped with stainless steel rolls. The pastes were passed over the mill several times whereby the gaps (gap 1 between first and second roll, gap 2 between second and third roll) between the rolls were reduced step wise. The following values were applied for the gaps (gap 1/gap 2) and for the pressure (number of passes at pressure gap 1/gap 2): 60 µm/40 µm (5/5 N/mm), 60 µm/20µm (2x 7/8 N/mm), 60 µm/10µm (2x 9/10 N/mm), 15 µm/15 µm (2x 11/12 N/mm), 5µm/5µm (3x 14/15 N/mm). The speed of first and third roll was 300 rpm.

### Viscosity

Viscosity measurements were performed using the Thermo Fischer Scientific Corp. "Haake Rheostress 6000" equipped with a ground plate MPC60 Ti and a cone plate C 20/0,5° Ti and software "Haake RheoWin Job Manager 4.00.0003". After setting the distance zero point, a paste sample sufficient for the measurement was placed on the ground plate. The cone was moved into the measurement positions with a gap distance of 0.026 mm and excess material was removed using a spatula. The sample was equilibrated to 25 °C for three minutes and the rotational measurement started. The shear rate was increased from 0 to 20 s⁻¹ within 48 s and 24 equidistant measuring points and further increased to 150 s⁻¹ within 312 s and 156 equidistant measuring points. After a waiting time of 60 s at a shear rate of 150 s⁻¹, the shear rate was reduced from 150 s⁻¹ to 20 s⁻¹ within 312 s and 156 equidistant measuring points and further reduced to 0 within 48 s and 24 equidistant measuring points. The micro torque correction, micro stress control and mass inertia correction were activated. The viscosity is given as the measured value at a shear rate of 100 s⁻¹ of the downward shear ramp.

### Specific Surface Area

BET measurements to determine the specific surface area of Cu particles are made in accordance with DIN ISO 9277:1995. A Gemini VII 2390 (from Micromeritics) with software V1.03 which works according to the SMART method (Sorption Method with Adaptive dosing Rate), is used for the measurement. As reference material Alpha Aluminum oxide CRM BAM-PM-102 available from BAM (Bundesanstalt für Materialforschung und -prüfung) is used. Filler rods are added to the reference and sample cuvettes in order to reduce the dead volume. The cuvettes are mounted on the BET apparatus. The saturation vapor pressure of nitrogen gas (N₂ 5.0) is determined. A sample is weighed into a glass cuvette in such an amount that the cuvette with the filler rods is completely filled and a minimum of dead volume is created. The sample is kept at 80°C for 2 hours in order to dry it. After cooling the weight of the sample is recorded. The glass cuvette containing the sample is mounted on the measuring apparatus. To degas the sample, it is evacuated at a pumping speed selected so that no material is sucked into the pump. The mass of the sample after degassing is used for the calculation. The dead volume is determined using Helium gas (He 4.6). The glass cuvettes are cooled to 77 K using a liquid nitrogen bath. For the adsorptive, N₂ 5.0 with a molecular cross-sectional area of 0.162 nm² at 77 K is used for the calculation. A multi-point analysis with 5 measuring points is performed and the resulting specific surface area given in m²/g.

### Substrates

Printing was performed on Al₂O₃ substrates of 2x2 inch and a thickness of 0.63 mm (Rubalit 708 S from CeramTec GmbH) non-treated AlN substrates of 2x2 inch and a thickness of 0.63 mm (from Maruwa Co. Ltd.). Pretreatment of AlN substrates were produced by heating non-treated AlN substrates in air at about 1150°C for about 90 minutes.

### Screen printing

Printing was performed using a screen from Koenen GmbH with a specific pattern on a EKRA Microtronic II printer (type M2H). The Emulsion over mesh was about 50 µm, the screen had 80 mesh and 65 µm stainless steel wire with an mesh size of 245 µm. The printing parameters were 63 N squeegee pressure, forward squeegee speed 100 mm/s and flooding speed 100 mm/s and a snap off of 1.0 mm. Thereby a film thickness of 100 µm after printing (wet), 60 µm after drying and 50 um after firing was obtained. The thus obtained Cu layes have an square shaped area of 2 cm*2 cm.

### Drying

10 minutes after printing the samples were paced in a drying apparatus HHG-2 (from BTU International Inc.) and dried at 150°C in 10 minutes.

### Firing

The printed pastes were sintered by firing them in a box furnace (ATV Technologie GmbH, type PEO 603). The temperature was increased from 25°C to 920°C within 20 minutes, remained at 920°C for a holding time of 10 minutes and was reduced from 920 °C to about 25°C within 20 minutes. During the whole procedure nitrogen (N2 5.0) was purged through the furnace at a flow rate of 3500 1/h.

### Apply-dry-fire cycle

The process steps of printing, drying and firing, each applying the described above conditions, were repeated at least 1 time, up to 10 times. During printing the same sieve was used and the substrate and sieve were oriented in a way that the subsequent layer covered at least 90 % of the area of the preceding layer.

### Film thickness

To measure film thickness a profiler system Hommel-Etamic-Tester T8000 with software Turbo-Wave V7.53 (both from Jenoptik) was used. The probe TKLT 300/17 was moved across the surface over a distance of 2.5 mm at a speed of 0.5 mm/s. The scan was made perpendicular to the rim of a printed film. 32 such scans were made and the average value is given as result.

### Sheet Resistance

For measuring the sheet resistance, a multimeter from the company Keithley (Keithley DMM 2750, Keithley 7002 Switch System) is used. The sheet resistance is deduced using the Ohmic law in Ω/square. The electrodes were placed on the opposite ends of a conducting line with a length of 65 mm and a width of 5 mm (=130 squares) and the resistance was noted. To determine the average sheet resistance, the measurement was performed at least 10 times and the average of the resistance value divided by the number of squares resulted the sheet resistance. The values are normalized to a fired film thickness of 50 µm. The normalized sheet resistance was obtained by dividing the measured film thickness by the norm thickness multiplied with the average resistance value.

### Adhesion

Adhesion of a layer obtained by a single printing after firing and a fired film thickness of about 50 µm was evaluated on small quadratic patches with about 1 mm length. A spatula was used to apply force from one side to the pad trying to lift it off. A small force and easy detachment was denoted with "-", a medium force with "o", a high force with "+" and the best results are denoted "++".

### Bond Adhesion

Sample preparation: A Al-metal wire with a diameter of 300 µm (Al H11, commercially available from Heraeus Materials Technology GmbH & Co. KG) is bonded via ultrasonic treatment with a Bonder Orthodyne 360 B equipped with a bonding wedge Ortho 127153-20 (all from Orthodyne Electronics GmbH), on to the surface of a Cu layer obtained in the below examples. The below given bonding parameter are applied:

| **Parameter** | **Setting** |
|---|---|
| force | 820 |
| bond 1 US | 182 |
| bond 2 US | 185 |
| bond 1 time | 230 |
| bond 2 time | 255 |
| loop value | 80 |
| desc. delay | 60 |
| bond delay | 0 |
| search height | 200 |
| turn height | 120 |
| hop distance. | 1600 |
| vert. hop | 90 |
| break distance | 200 |
| break height | 20 |
| step forward | -15 |
| touch force | 300 |
| break distance | 200 |
| break height | 20 |
| step forward | -15 |
| touch force | 300 |

Testing conditions: Using the tensile test according to EN 10002-1 is performed. The force is applied perpendicular to the surface of the copper layer. The speed of the moving clamp is set to 500 µm/s and the force is increased continuously until break. The above test is repeated for 20 samples, prepared according to the above sample preparation proceedings. The number of wire breaks is counted and provided in % based on the total number of tested samples.

### Thermo Cycling

For thermo cycling the thermo shock chamber Espec TSE-11-A (from ESPEC North America, Inc.) consisting of two separate chambers, one for high temperature (150°C), one for low temperature (-40°C) is used. The substrate is kept 30 min in each chamber before changing to the other chamber for completing a cycle.

### Color

The color of the composition according to any embodiment of the invention is given by color values in the CIE L*a*b* color space defined in the international standard EN ISO 11664-4. Color measurements were performed using a Konica Minolta Spectrophotometer CM-700d (from Konica Minolta Sensing Europe B.V.) in the CIE L*a*b* color space system. After calibration with a "black Whole" and a white tile measurements were performed by placing the instrument on a dried or fired copper layer. 5 measurements were recorded and averaged.

### Particle Size Determination (D₁₀, D₅₀, D₉₀)

Particle size determination for particles is performed in accordance with ISO 13317-3:2001. A Sedigraph 5100 with software Win 5100 V2.03.01 (from Micromeritics GmbH) which works according to X-ray gravitational technique is used for the measurement. A sample of about 400 to 600 mg is weighed into a 50 ml glass beaker and 40 ml of Sedisperse P11 (from Micromeritics, with a density of about 0.74 to 0.76g/cm³ and a viscosity of about 1.25 to 1.9 mPa·s) are added as suspending liquid. A magnetic stirring bar is added to the suspension. The sample is dispersed using an ultrasonic probe Sonifer 250 (from Branson Ultrasonic Corporation) operated at power level 2 for 8 minutes while the suspension is stirred with the stirring bar at the same time. This pre-treated sample is placed in the instrument and the measurement started. The temperature of the suspension is recorded (typical range 24°C to 45°C) and for calculation data of measured viscosity for the dispersing solution at this temperature are used. Using density and weight of the sample (8.92 g/cm³ for Cu) the particle size distribution is determined and given as D₁₀, D₅₀ and D₉₀.

### Oxygen content of Cu particles

The determination of the oxygen content of copper powder was performed according to ASTM E1019-03 with an oxygen analyzer TC 436 (from Leco Corporation, USA) in which the oxygen content is determined indirectly via transformation into CO₂. The principle is the following: The sample is heated in the presence of graphite whereby the oxygen reacts to form CO. The CO is transformed into CO₂ by passing through a copper oxide column ((Cu(II)O) from Leco Corporation) which is operated at 600°C. The CO₂ is recorded using an infrared sensor. The conditioning of the and the calibration of the instrument is performed with a known amount of CO₂ gas and with certified steel standards from Leco Corporation which have an oxygen content close to the samples to be measured. About 20 to 50 mg of the sample are paced in a tin capsule from Leco Corporation. The capsule was placed in a graphite crucible (from Leco Corporation) which has been degased two times 30 seconds at 2700°C (5900W). Both were then placed in the instrument and heated to 2500°C (5100W). To determine the zero value an empty tin capsule was measured three times under identical conditions in advance and the average was subtracted from the value obtained with sample. Each sample was measured three times and the average is given as result.

### Scanning electron microscopy SEM

The sample is cut in a way that the area of interest is laid open. In this case perpendicular to the surface of the substrate so that a cross section of the different layers was obtained.. The cut sample is placed in a container filled with embedding material and oriented such that the area of interest is on top. As embedding material, EpoFix (Struers GmbH) is used, mixed according to the instructions. After 8 hours curing at room temperature the sample can be processed further. In a first step the sample is ground with a Labopol-25 (Struers GmbH) using silicon carbide paper 180-800 (Struers GmbH) at 250 rpm. In further steps the sample is polished using a Rotopol-2 equipped with a Retroforce-4, MD Piano 220 and MD allegro cloth and DP-Spray P 3µm diamond spray (all from Struers GmbH). The examination was performed with a Zeiss Ultra 55 (Carl Zeiss AG), equipped with a field emission electrode, an accelerating voltage of 20 kV and at a pressure of about 3*10⁻⁶ mbar. In some cases the cross sections were used to determine the elemental composition along a line across the different layers and perpendicular to the substrate surface. so called line scan was performed using an EDX measurement (*energy dispersive X-ray spectroscopy*). A IncaPentaFETx3 attached to the Zeiss Ultra 55 and the software "The Microanalysis Suite Issue 18d + SP3" (both from Oxford Instruments) with an aperture of 30 µm were used.

### Preparation of pastes

426.55 g Cu powder were mixed with 52.0 g of the organic vehicle V, 26.8 g Bi oxide (from MCP) and 1.65 g Cu (I) oxide (from Riedel de Haen GmbH) and homogenized with the 3 roll mill. The pastes had viscosity of about 45 mPa s and were screen printable. After printing onto substrates samples were dried and fired. The apply-dry-fire cycle was repeated up to 7 times. A homogeneous copper layer was obtained when copper powder with a high O content was used, even after multiple apply-dry-fire cycles. Results are summarized in table 2.

### Tap density

The tap density was measured according to the standard ISO 3953.

**Table 2:**

| Sample with powder | number of apply-dry-fire cycles | L* dried | a* dried | L* fired | a* fired | Adhesion on Al₂O₃ | Adhesion on non-treated AlN | Adhesion on pre-treated AlN | Sheet resistance normalized to 50 µm film thickness in mΩ/square |
|---|---|---|---|---|---|---|---|---|---|
| P1 | 1 | 64.02 | 12.64 | 84.95 | 12.82 | + | - | - | 0.5 |
| P2 | 1 | 49.35 | 14.99 | 78.99 | 16.19 | ++ | o | + | 0.6 |
| P3 | 1 | 57.36 | 16.73 | 78.38 | 17.33 | ++ | o | + | 0.6 |
| P4 | 1 | 48.46 | 15.03 | 82.28 | 13.86 | ++ | o | + | 0.6 |

**Table 3:**

| Sample with powder | number of apply-dry-fire cycles | Bond Adhesion on Al₂O₃ | Bond Adhesion on pre treated AlN | Bond Adhesion on Al₂O₃ after thermocycling (500 cycles) | Bond Adhesion on pre treated AlN after thermocycling (500 cycles) |
|---|---|---|---|---|---|
| P1 | 7 | na | na | na | na |
| P2 | 7 | 95% wire break | 95% wire break | 90% wire break | 90% wire break |
| P3 | 7 | 100 % wire break | 100 % wire break | 95 % wire break | 95 % wire break |
| P4 | 7 | 100 % wire break | 100 % wire break | 95 % wire break | 95 % wire break |

| | | | | | |
|---|---|---|---|---|---|
| na = not available, due to blistering during drying and/or firing - no bonding possible | | | | | |

### FIGURES

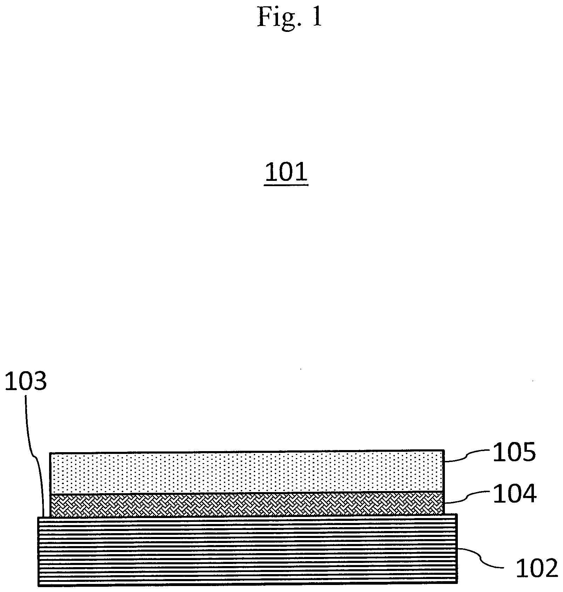

Figure 1 shows a cross sectional side view of a composite 101 according to the invention. The composite 101 comprises a substrate 102, a second layer 104 and a third layer 105. The second layer 104 superimposes the substrate surface 103 and the second layer 104 is in direct contact with the substrate surface 103. The third layer 105 superimposes the second layer 104 and the substrate surface 103. The third layer 105 is in direct contact with a surface of the second layer 104.

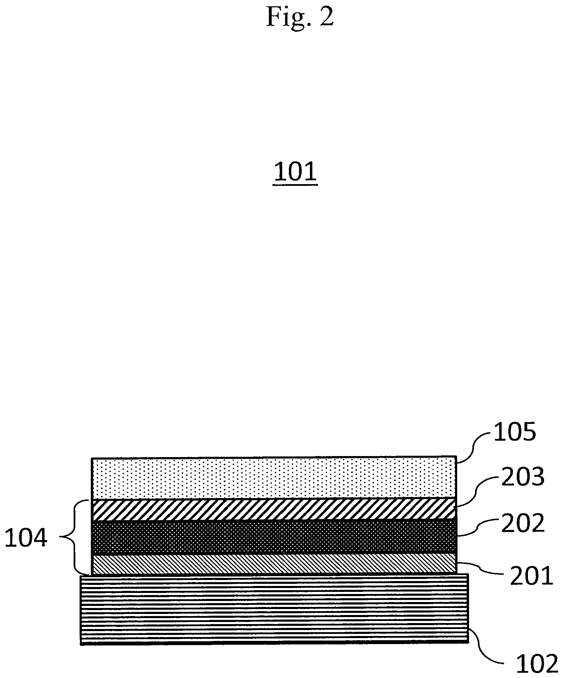

Figure 2 shows a cross sectional side view of a composite 101 according to figure 1. Additionally to the composite 101 of figure 1 the second layer 104 of the composite 101 of figure 2 comprises a first sublayer 201, a second sublayer 202 and a third sublayer 203. The sublayers 201, 202 and 203 are spatially located completely within the second layer 104. Surfaces of the sublayers 201, 202 and 203 are oriented in the same direction as surfaces of the second layer 104. Moreover, the second layer 104 consists of the first sublayer 201, the second sublayer 202 and the third sublayer 203.

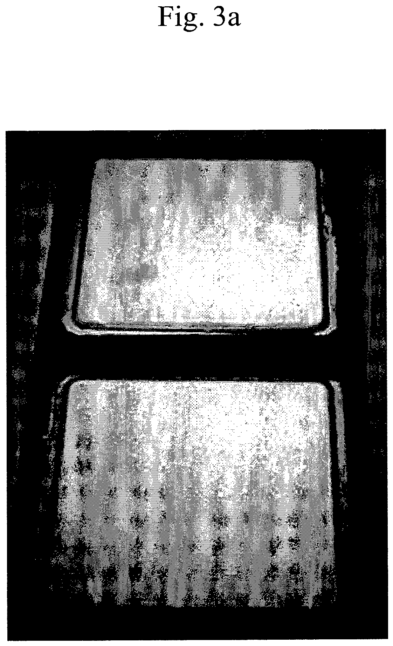

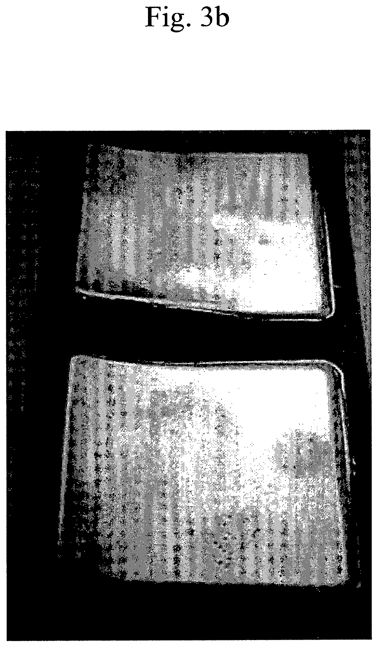

Figure 3a and 3b show photographs of two Cu layers on a peroxidised AlN substrate. The Cu layer depicted in Figure 3a is made from the paste composition sample P3 according to the invention. The Cu layer depicted in Figure 3b is made from the comparative paste composition sample P1. Figure 3a shows almost no blisters. However, according to Figure 3b, heavy blister formation and delamination form the substrate occurred during firing.

### LIST OF REFERENCES

- **101**: composite
- **102**: substrate layer
- **103**: substrate surface
- **104**: second layer
- **105**: third layer
- **201**: first sublayer
- **202**: second sublayer
- **203**: third sublayer

## Claims

1. A composition comprising as constituents:
a. at least 2 wt.-% of a vehicle;
b. at least 42 wt.-% of Cu particles;
each based on the weight of the total composition with the wt.-% of the constituents adding to 100 wt.-%;
wherein the composition has color values of L* less than 60 and a* more than 14, each according to the L*a*b* color space, and
wherein the Cu particles have an oxygen content in the range from 0.4 to 0.8 wt.-%, based on the total weight of the Cu particles, and wherein the oxygen content of the Cu particles is based on Cu oxide resulting from a heat treatment of Cu in an oxidizing atmosphere at a temperature ranging from 100 to 200 °C,
**characterized in that** the composition further comprises Bi₂O₃ in the range from 2 to 10 wt.-%, based on the weight of the total composition, and
Cu oxide in the range from 0.01 to 0.5 wt.-%, based on the weight of the total composition.

2. The composition according to any of the preceding claims, wherein the Cu particles have a particle size distribution **characterized by**:
a. a D₁₀ in the range from 0.5 to 3 µm ;
b. a D₅₀ in the range from 1 to 13 µm; and
c. a D₉₀ in the range from 2 to 22 µm.

3. The composition according to any of the preceding claims, wherein Cu particles have a specific surface area according to BET in the range from 0.01 to 40 m²/g.

4. The composition according to any of the preceding claims, wherein the composition further comprises an inorganic reaction system, capable of forming a glass; or a glass frit; or both.

5. The composition according to any of the preceding claims, wherein the composition comprises less than 0.005 wt.-% of Pb based on the total weight of the composition.

6. The composition according to any of the claims 1 to 5, wherein the composition fulfills at least one of the following criteria:
a. a viscosity in the range from 10 to 100 Pa s;
b. color values of the fired composition of L* less than 84 and a* more than 13, each according to the L*a*b* color space;
c. a sheet resistance of the fired composition of less than 1,2 mΩ/square; or
d. at least 90 % wire break.

7. A process for making a composition according to claim 1, comprising the steps:
a. providing Cu particles,
wherein the Cu particles comprise less than 0.25 wt.-% of oxygen based on the total weight of the Cu particles;
b. heating the Cu particles in an oxidizing atmosphere to a temperature in the range from 100 to 200 °C to obtain pre-oxidized Cu particles, wherein the pre-oxidized Cu particles comprise oxygen in the range from 0.4 to 0.8 wt.-% based on the total weight of the pre-oxidized Cu particles;
c. mixing as constituents:
i) the pre-oxidized Cu particles in an amount of at least 42 wt.-%,
ii) a vehicle in an amount of at least 2 wt.-%,
iii) Bi₂O₃ in an amount of 2 to 10 wt.-%, and
iv) Cu oxide in an amount of 0.01 to 0.5 wt.-%,
each based on the total weight of the mixed constituents with the wt.-% of the constituents adding to 100 wt.-%,
wherein the composition has color values of L* less than 60 and a* more than 14, each according to the L*a*b* color space.

8. A process for making a composite, comprising the steps
a. providing a substrate with a substrate surface;
b. superimposing a composition comprising
i) at least 2 wt.-% of a vehicle,
ii) Cu particles in an amount of at least 42 wt.-%,
each based on the total weight of the composition with the wt.-% of the constituents adding to 100 wt.-%,
wherein the composition has color values of L* less than 60 and a* more than 14, each according to the L*a*b* color space, wherein the Cu particles comprise oxygen in the range from 0.4 to 0.8 wt.-% based on the total weight of the Cu particles, wherein the composition further comprises
a. Bi₂O₃ in the range from 2 to 10 wt.-%;
b. Cu oxide in the range from 0.01 to 0.5 wt.-%;
each based on the total weight of the composition with the wt.-% of the constituents adding to 100 wt.-%,
on the substrate surface in order to obtain a composite precursor;
c. firing the composite precursor.

9. The process according to claim 8, wherein
a. the substrate comprises at least 70 wt.-% of AlN, based on the total weight of the substrate;
b. the process comprises as further steps before superimposing:
i) heating the substrate to a temperature in the range of 1000 to 1300°C,
ii) exposing the hot substrate to an oxidizing atmosphere.

10. The process according to any of the claims 8 or 9, wherein the thickness of the composition superimposed on the substrate surface is a non-constant function of the location on the substrate surface.

11. The process according to any of the claims 8 or 10, wherein the superimposing is realized as one selected from the group consisting of screen printing, stencil printing, tampon printing, dispensing through a nozzle, or a combination of at least two thereof.

12. A composite obtainable by the process according to any of the claims 8 to 11.

13. The composite according to claim 12, wherein the substrate layer has a thickness in the range of 0.01 to 10 mm;

14. An electronic device comprising the composite according to any of the claims 12 or 13.

15. The electronic device according to claim 14, wherein the device is selected from the group consisting of a high-power device, a high-power diode, a micro-electronic device, a sensor, a transmitter, a thick-film component, a thin-film component, a component of a satellite, an electronic circuit, an integrated electronic circuit, a heating device, a cooling device, a laser diode, a power converter, an electric motor, or a combination of at least two thereof.

## Patentansprüche

1. Zusammensetzung, enthaltend als Bestandteile:
a. mindestens 2 Gew.-% einer Trägersubstanz;
b. mindestens 42 Gew.-% Cu-Partikel;
jeweils bezogen auf das Gewicht der Gesamtzusammensetzung, wobei sich die Gew.-% der Bestandteile auf 100 Gew.-% addieren;
wobei die Zusammensetzung Farbwerte von L* kleiner als 60 und a* größer als 14 aufweist, jeweils gemäß dem L*a*b*-Farbraum, und
wobei die Cu-Partikel einen Sauerstoffgehalt im Bereich von 0,4 bis 0,8 Gew.-%, bezogen auf das Gesamtgewicht der Cu-Partikel, aufweisen und
wobei der Sauerstoffgehalt der Cu-Partikel auf Cu-Oxid basiert, das aus einer Wärmebehandlung von Cu in einer oxidierenden Atmosphäre bei einer Temperatur in einem Bereich von 100 bis 200 °C entsteht,
**dadurch gekennzeichnet, dass** die Zusammensetzung ferner enthält
Bi₂O₃ im Bereich von 2 bis 10 Gew.-%, bezogen auf das Gewicht der Gesamtzusammensetzung, und
Cu-Oxid im Bereich von 0,01 bis 0,5 Gew.-%, bezogen auf das Gewicht der Gesamtzusammensetzung.

2. Zusammensetzung nach einem der vorangehenden Ansprüche, wobei die Cu-Partikel eine Partikelgrößenverteilung aufweisen, die **gekennzeichnet ist durch**:
a. ein D₁₀ im Bereich von 0,5 bis 3 µm;
b. ein D₅₀ im Bereich von 1 bis 13 µm; und
c. ein D₉₀ im Bereich von 2 bis 22 µm.

3. Zusammensetzung nach einem der vorangehenden Ansprüche, wobei Cu-Partikel einen spezifischen Oberflächenbereich gemäß BET im Bereich von 0,01 bis 40 m²/g aufweisen.

4. Zusammensetzung nach einem der vorangehenden Ansprüche, wobei die Zusammensetzung ferner ein anorganisches Reaktionssystem enthält, das in der Lage ist, ein Glas oder eine Glasfritte oder beides zu bilden.

5. Zusammensetzung nach einem der vorangehenden Ansprüche, wobei die Zusammensetzung weniger als 0,005 Gew.-% Pb, bezogen auf das Gesamtgewicht der Zusammensetzung, enthält.

6. Zusammensetzung nach einem der Ansprüche 1 bis 5, wobei die Zusammensetzung zumindest eines der folgenden Kriterien erfüllt:
a. eine Viskosität im Bereich von 10 bis 100 Pa s;
b. Farbwerte der gebrannten Zusammensetzung von L* weniger als 84 und a* mehr als 13, jeweils gemäß dem L*a*b*-Farbraum;
c. einen Schichtwiderstand der gebrannten Zusammensetzung von weniger als 1,2 mΩ/Quadrat; oder
d. zumindest 90 % Drahtbruch.

7. Verfahren zur Herstellung einer Zusammensetzung nach Anspruch 1, umfassend die Schritte:
a. Bereitstellen von Cu-Partikeln,
wobei die Cu-Partikel weniger als 0,25 Gew.-% Sauerstoff, bezogen auf das Gesamtgewicht der Cu-Partikel, enthalten;
b. Erhitzen der Cu-Partikel in einer oxidierenden Atmosphäre auf eine Temperatur im Bereich von 100 bis 200 °C, um voroxidierte Cu-Partikel zu erhalten, wobei die voroxidierten Cu-Partikel Sauerstoff im Bereich von 0,4 bis 0,8 Gew.-%, bezogen auf das Gesamtgewicht der voroxidierten Cu-Partikel, enthalten;
c. Vermengen als Bestandteile:
i) die voroxidierten Cu-Partikel in einer Menge von zumindest 42 Gew.-%,
ii) eine Trägersubstanz in einer Menge von zumindest 2 Gew.-%,
iii) Bi₂O₃ in einer Menge von 2 bis 10 Gew.-%, und
iv) Cu-Oxid in einer Menge von 0,01 bis 0,5 Gew.-%,
jeweils bezogen auf das Gesamtgewicht der beigemischten Bestandteile, wobei sich die Gew.-% der Bestandteile auf 100 Gew.-% addieren,
wobei die Zusammensetzung Farbwerte von L* kleiner als 60 und a* größer als 14 aufweist, jeweils gemäß dem L*a*b*-Farbraum.

8. Verfahren zum Herstellen eines Verbundstoffs, umfassend die Schritte:
a. Bereitstellen eines Substrats mit einer Substratoberfläche;
b. Aufbringen einer Zusammensetzung enthaltend
i) zumindest 2 Gew.-% einer Trägersubstanz,
ii) Cu-Partikel in einer Menge von zumindest 42 Gew.-%,
jeweils bezogen auf das Gesamtgewicht der Zusammensetzung, wobei sich die Gew.-% der Bestandteile auf 100 Gew.-% addieren,
wobei die Zusammensetzung Farbwerte von L* kleiner als 60 und a* größer als 14 aufweist, jeweils gemäß dem L*a*b*-Farbraum,
wobei die Cu-Partikel Sauerstoff im Bereich von 0,4 bis 0,8 Gew.-%, bezogen auf das Gesamtgewicht der Cu-Partikel, enthalten,
wobei die Zusammensetzung ferner umfasst:
a. Bi₂O₃ im Bereich von 2 bis 10 Gew.-%;
b. Cu-Oxid im Bereich von 0,01 bis 0,5 Gew.-%;
jeweils bezogen auf das Gesamtgewicht der Zusammensetzung, wobei sich die Gew.-% der Bestandteile auf 100 Gew.-% addieren,
auf die Substratoberfläche, um einen Verbundstoff-Vorläufer zu erhalten;
c. Brennen des Verbundstoff-Vorläufers.

9. Verfahren nach Anspruch 8, wobei
a. das Substrat zumindest 70 Gew.-% AIN, bezogen auf das Gesamtgewicht des Substrats, enthält;
b. das Verfahren als weitere Schritte vor dem Aufbringen umfasst:
i) Erhitzen des Substrats auf eine Temperatur im Bereich von 1000 bis 1300°C,
ii) Aussetzen des heißen Substrats an eine oxidierende Atmosphäre.

10. Verfahren nach einem der Ansprüche 8 oder 9, wobei die Dicke der auf die Substratoberfläche aufgebrachten Zusammensetzung eine nicht konstante Funktion der Position auf der Substratoberfläche ist.

11. Verfahren nach einem der Ansprüche 8 oder 10, wobei das Aufbringen als eines aus der Gruppe bestehend aus Siebdruck, Schablonendruck, Tampondruck, Auftrag durch eine Düse, oder einer Kombination aus mindestens zwei davon, realisiert ist.

12. Verbundstoff, erhältlich durch das Verfahren nach einem der Ansprüche 8 bis 11.

13. Verbundstoff nach Anspruch 12, wobei die Substratschicht eine Dicke im Bereich von 0,01 bis 10 mm aufweist.

14. Elektronische Einrichtung, enthaltend den Verbundstoff nach einem der Ansprüche 12 oder 13.

15. Elektronische Einrichtung nach Anspruch 14, wobei die Einrichtung ausgewählt ist aus der Gruppe bestehend aus einer Hochleistungseinrichtung, einer Hochleistungsdiode, einer mikroelektronischen Einrichtung, einem Sensor, einem Sender, einer Dickschichtkomponente, einer Dünnschichtkomponente, einer Satellitenkomponente, einer elektronischen Schaltung, einer integrierten elektronischen Schaltung, einer Heizeinrichtung, einer Kühleinrichtung, einer Laserdiode, einem Leistungswandler, einem Elektromotor, oder einer Kombination aus mindestens zwei davon.

## Revendications

1. Composition comprenant, en tant que constituants :
a. au moins 2 % en poids d'un véhicule ;
b. au moins 42 % en poids de particules de Cu ;
chacun exprimé par rapport au poids de la composition totale, la somme des pourcentages en poids des constituants étant de 100 % en poids ;
laquelle composition a des valeurs de couleur L* inférieure à 60 et a* supérieure à 14, chacune conformément à l'espace colorimétrique L*a*b*, et
dans laquelle les particules de Cu ont une teneur en oxygène comprise dans la plage allant de 0,4 à 0,8 % en poids par rapport au poids total des particules de Cu, et
la teneur en oxygène des particules de Cu étant basée sur l'oxyde de Cu résultant d'un traitement à la chaleur de Cu dans une atmosphère oxydante à une température comprise dans la plage allant de 100 à 200°C,
**caractérisée en ce que** la composition comprend en outre
du Bi₂O₃ à raison de 2 à 10 % en poids par rapport au poids de la composition totale, et de l'oxyde de Cu à raison de 0,01 à 0,5 % en poids par rapport au poids de la composition totale.

2. Composition selon la revendication précédente, dans laquelle les particules de Cu ont une distribution de granulométrie **caractérisée par** :
a. une valeur D₁₀ comprise dans la plage allant de 0,5 à 3 µm;
b. une valeur D₅₀ comprise dans la plage allant de 1 à 13 µm; et
c. une valeur D₉₀ comprise dans la plage allant de 2 à 22 µm.

3. Composition selon l'une quelconque des revendications précédentes, dans laquelle les particules de Cu ont une surface spécifique selon BET comprise dans la plage allant de 0,01 à 40 m²/g.

4. Composition selon l'une quelconque des revendications précédentes, laquelle composition comprend en outre un système réactionnel inorganique, capable de former un verre ; ou une fritte de verre ; ou les deux.

5. Composition selon l'une quelconque des revendications précédentes, laquelle composition comprend moins de 0,005 % en poids de Pb par rapport au poids total de la composition.

6. Composition selon l'une quelconque des revendications 1 à 5, laquelle composition satisfait à au moins l'un des critères suivants :
a. une viscosité comprise dans la plage allant de 10 à 100 Pa.s ;
b. des valeurs de couleur de la composition cuite de L* inférieure à 84 et a* supérieure à 13, chacune conformément à l'espace colorimétrique L*a*b*;
c. une résistance en feuille de la composition cuite inférieure à 1,2 mΩ/carré; ou
d. une rupture de fil d'au moins 90 %.

7. Procédé pour préparer une composition selon la revendication 1, comprenant les étapes consistant à :
a. disposer de particules de Cu, lesquelles particules de Cu comprennent moins de 0,25 % en poids d'oxygène par rapport au poids total des particules de Cu ;
b. chauffer les particules de Cu dans une atmosphère oxydante à une température comprise dans la plage allant de 100 à 200°C pour obtenir des particules de Cu pré-oxydées, lesquelles particules de Cu pré-oxydées comprennent de l'oxygène à raison de 0,4 à 0,8 % en poids, par rapport au poids total des particules de Cu pré-oxydées ;
c. mélanger, en tant que constituants :
i) les particules de Cu pré-oxydées en une quantité d'au moins 42 % en poids,
ii) un véhicule en une quantité d'au moins 2 % en poids,
iii) du Bi₂O₃ en une quantité de 2 à 10 % en poids, et
iv) de l'oxyde de Cu en une quantité de 0,01 à 0,5 % en poids,
chacun exprimé par rapport au poids total des constituants mélangés, la somme des pourcentages en poids des constituants étant de 100 % en poids,
dans lequel la composition a des valeurs de couleur L* inférieure à 60 et a* supérieure à 14, chacune conformément à l'espace colorimétrique L*a*b*.

8. Procédé pour préparer un composite, comprenant les étapes consistant à
a. disposer d'un substrat avec une surface de substrat ;
b. superposer une composition comprenant
i) au moins 2 % en poids d'un véhicule,
ii) des particules de Cu en une quantité d'au moins 42 % en poids,
chacun exprimé par rapport au poids total de la composition, la somme des pourcentages en poids des constituants étant de 100 % en poids,
laquelle composition a des valeurs de couleur L* inférieure à 60 et a* supérieure à 14, chacune conformément à l'espace colorimétrique L*a*b*,
lesquelles particules de Cu comprennent de l'oxygène à raison de 0,4 à 0,8 % en poids par rapport au poids total des particules de Cu,
laquelle composition comprend en outre
a. du Bi₂O₃ à raison de 2 à 10 % en poids ;
b. de l'oxyde de Cu à raison de 0,01 à 0,5 % en poids ;
chacun exprimé par rapport au poids total de la composition, la somme des pourcentages en poids des constituants étant de 100 % en poids,
sur la surface de substrat afin d'obtenir un précurseur de composite ;
c. cuire le précurseur de composite.

9. Procédé selon la revendication 8, dans lequel
a. le substrat comprend au moins 70 % en poids d'AIN, par rapport au poids total du substrat ;
b. le procédé comprend, avant la superposition, d'autres étapes consistant à :
i) chauffer le substrat à une température comprise dans la plage allant de 1000 à 1300°C,
ii) exposer le substrat chaud à une atmosphère oxydante.

10. Procédé selon l'une quelconque des revendications 8 et 9, dans lequel l'épaisseur de la composition superposée sur la surface de substrat est une fonction non constante de l'emplacement sur la surface de substrat.

11. Procédé selon l'une quelconque des revendications 8 et 10, dans lequel la superposition est réalisée sous une forme choisie dans le groupe constitué par une sérigraphie, une impression au stencil, une impression au tampon, une distribution par une buse, ou une combinaison d'au moins deux de celles-ci.

12. Composite pouvant être obtenu par le procédé selon l'une quelconque des revendications 8 à 11.

13. Composite selon la revendication 12, dans lequel la couche de substrat a une épaisseur comprise dans la plage allant de 0,01 à 10 mm.

14. Dispositif électronique comprenant le composite selon l'une quelconque des revendications 12 et 13.

15. Dispositif électronique selon la revendication 14, lequel dispositif est choisi dans le groupe constitué par un dispositif haute puissance, une diode haute puissance, un dispositif microélectronique, un capteur, un transmetteur, un composant en film épais, un composant en film mince, un composant d'un satellite, un circuit électronique, un circuit électronique intégré, un dispositif chauffant, un dispositif réfrigérant, une diode à laser, un convertisseur de puissance, un moteur électrique, ou une combinaison d'au moins deux de ceux-ci.
